# EUROPÄISCHE PATENTANMELDUNG

(11) **EP 3 413 696 A1**
(43) Veröffentlichungstag der Anmeldung: **12.12.2018**
(21) Anmeldenummer: 18171463.5
(22) Anmeldetag: 09.05.2018
(51) Int. Cl.: H05K 5/02

(54) **GEHÄUSE FÜR EINE ELEKTRIK ODER ELEKTRONIKKOMPONENTE**

(30) Priorität: 30.05.2017 DE 102017209030
(71) Anmelder: Mahle International GmbH, 70376 Stuttgart (DE)
(72) Erfinder: BIELESCH, Thomas, 75417 Mühlacker (DE); BÖHM, Michael, 70619 Stuttgart (DE); STASCH, Wojciech, 70499 Stuttgart (DE)
(74) Vertreter: BRP Renaud & Partner mbB Rechtsanwälte Patentanwälte Steuerberater

(57) **Zusammenfassung**

Die Erfindung betrifft ein Gehäuse (10) für eine Elektrik- und/oder Elektronikkomponente (12), das einen Innenraum (16) umschließt, in welchem elektrische und/oder elektronische Bauteile (29) aufgenommen werden können, mit einer äußeren Druckausgleichsöffnung (38) in einer Gehäusewand (14) und mit einer ersten Flüssigkeitsrückhaltevorrichtung (40), die das Eindringen von Flüssigkeit, insbesondere Wasser, durch die äußere Druckausgleichsöffnung (38) in den Innenraum (16) behindert, wobei die erste Flüssigkeitsrückhaltevorrichtung (40) eine Druckausgleichsmembran (42) aufweist, welche gasdurchlässig und wasserabweisend ist und welche die äußere Druckausgleichsöffnung (38) abdeckt.

Um einen verbesserten Schutz gegen Eindringen von Wasser zu ermöglichen, wird vorgeschlagen, dass das Gehäuse (10) eine zweite Flüssigkeitsrückhaltevorrichtung (44) aufweist, welche in dem Innenraum (16) des Gehäuses (10) angeordnet ist und welche Flüssigkeit, die durch die äußere Druckausgleichsöffnung (38) in das Gehäuse (10) eintritt, zumindest teilweise auffängt.

## Beschreibung

Die Erfindung betrifft ein Gehäuse für eine Elektrik- und/oder Elektronikkomponente, das einen Innenraum umschließt, in welchem elektrische und/oder elektronische Bauteile aufgenommen werden können, mit einer äußeren Druckausgleichsöffnung in einer Gehäusewand und mit einer ersten Flüssigkeitsrückhaltevorrichtung, die das Eindringen von Flüssigkeit, insbesondere Wasser, durch die äußere Druckausgleichsöffnung den Innenraum behindert, wobei die erste Flüssigkeitsrückhaltevorrichtung eine Druckausgleichsmembran aufweist, welche gasdurchlässig und wasserabweisend ist und welche die äußere Druckausgleichsöffnung abdeckt, insbesondere gemäß dem Oberbegriff des Anspruchs 1.

Solche Elektrik- und/oder Elektronikkomponenten sind durch Flüssigkeit, insbesondere Wasser, leicht zu beschädigen. Aufgrund von Temperaturschwankungen und Luftdruckschwankungen kann es allerdings erforderlich sein, dass ein Druckausgleich zwischen dem Druck im Innenraum des Gehäuses und dem Druck in der Umgebung erfolgen kann, um Beschädigungen am Gehäuse zu vermeiden. Daher ist aus dem Stand der Technik bekannt, eine äußere Druckausgleichsöffnung vorzusehen und diese mit einer Membran abzudecken, welche durchlässig aber wasserabweisend ist. Dadurch kann die Membran Wasser zurückhalten und somit die elektrischen oder elektronischen Bauteile schützen, während ein effektiver Druckausgleich ermöglicht ist.

Der Nachteil dieser Membranlösungen ist, dass diese Membranen vergleichsweise empfindlich sind und dass bei einer Beschädigung dieser Membran Wasser in das Gehäuse eindringen und somit die Elektrik- umd/oder Elektronikkomponenten beschädigen könnte.

Der vorliegenden Erfindung liegt die Aufgabe zugrunde, eine verbesserte oder zumindest alternative Ausführungsform eines Gehäuses für eine Elektrik- und/oder Elektronikkomponente bereitzustellen, die sich insbesondere durch einen verbesserten Schutz gegen Eindringen von Wasser auszeichnet.

Diese Aufgabe wird erfindungsgemäß durch die Gegenstände des unabhängigen Anspruchs gelöst. Vorteilhafte Weiterbildungen sind Gegenstand der abhängigen Ansprüche.

Die Erfindung beruht auf der Grundidee, eine zweite Flüssigkeitsrückhaltevorrichtung vorzusehen, welche bei Defekt der Druckausgleichsmembran Flüssigkeit, die durch die äußere Druckausgleichsöffnung in das Gehäuse eintritt, zumindest teilweise auffängt. Dadurch ist ein doppelter Schutz gegenüber eindringender Flüssigkeit, insbesondere eindringendem Wasser, gegeben. Erfindungsgemäß ist daher vorgesehen, dass das Gehäuse eine zweite Flüssigkeitsrückhaltevorrichtung aufweist, welche in dem Innenraum des Gehäuses angeordnet ist und welche Flüssigkeit, die durch die äußere Druckausgleichsöffnung in das Gehäuse eintritt, zumindest teilweise auffängt.

Eine vorteilhafte Ausführungsform sieht vor, dass die zweite Flüssigkeitsrückhaltevorrichtung einen Auffangraum aufweist, der an der äußeren Druckausgleichsöffnung angeordnet ist. Dadurch tritt Flüssigkeit, die durch die äußere Druckausgleichsöffnung in den Innenraum des Gehäuses eintritt zunächst in den Auffangraum ein, in welchem die Flüssigkeit zurückgehalten werden kann. Dadurch kann effektiv ein Eindringen der Flüssigkeit in den Bereich des Innenraums des Gehäuses, in welchem die elektrischen oder elektronischen Bauteile aufgenommen sind, verhindert werden.

Eine weitere vorteilhafte Ausführungsform sieht vor, dass der Auffangraum zumindest teilweise von einer Auffangraumwand und der Gehäusewand, in welcher die Druckausgleichsöffnung angeordnet ist, umschlossen ist. Dadurch dass zumindest eine Wand des Auffangraums durch die Gehäusewand gebildet ist, kann der Auffangraum kostengünstig und platzsparend ausgebildet werden. Insbesondere führt die Druckausgleichsöffnung direkt in den Auffangraum, so dass keine flüssigkeitsführenden Wände oder Kanäle zu dem Auffangraum hin benötigt werden.

Eine vorteilhafte Lösung sieht vor, dass das Gehäuse eine innere Druckausgleichsöffnung aufweist, die in der Auffangraumwand angeordnet ist und durch welche der Auffangraum mit dem Innenraum verbunden ist. Durch die innere Druckausgleichsöffnung ist der Auffangraum also mit dem Innenraum fluidisch verbunden, so dass ein Druckausgleich zwischen dem Innenraum und dem Auffangraum möglich ist. Durch die äußere Druckausgleichsöffnung kann ein Druckausgleich zwischen dem Auffangraum und der Umgebung ermöglicht werden. Durch die Kombination der inneren Druckausgleichsöffnung und der äußeren Druckausgleichsöffnung kann somit ein Druckausgleich zwischen dem Innenraum, in welchem die elektronischen oder elektrischen Bauteile angeordnet sind, und der Umgebung ermöglicht werden.

Eine weitere vorteilhafte Lösung sieht vor, dass die innere Druckausgleichsöffnung in Schwerkraftrichtung gesehen über der äußeren Druckausgleichsöffnung liegt. Dadurch kann Flüssigkeit, welche bei Beschädigung der Druckausgleichsmembran, durch die äußere Druckausgleichsöffnung in das Gehäuse einströmen kann, im Auffangraum aufgefangen werden, ohne dass diese Flüssigkeit direkt durch die innere Druckausgleichsöffnung in den Innenraum gelangen kann.

In der Beschreibung und den beigefügten Ansprüchen bezieht sich die Schwerkraftrichtung auf die vorgesehene Einbaulage.

Eine andere vorteilhafte Ausführungsform sieht vor, dass der Auffangraum einen Auffangraumboden umfasst, und dass der Auffangraumboden in Schwerkraftrichtung unterhalb der äußeren Druckausgleichsöffnung angeordnet ist. Dadurch ist in dem Auffangraum ein Volumen gebildet, in welchem Flüssigkeit zurückgehalten werden kann, ohne dass diese direkt in den Innenraum und somit zu den elektrischen oder elektronischen Komponenten gelangen kann. Der Auffangraum bildet somit eine Art Reservoir für die Flüssigkeit. Darüber hinaus bewirkt dies, dass das Reservoir in der Nähe der Druckausgleichsöffnung angeordnet ist, so dass bei gegebenen Bedingungen die Flüssigkeit durch die äußere Druckausgleichsöffnung das Gehäuse auch wieder verlassen kann.

Eine weitere vorteilhafte Ausführungsform Variante sieht vor, dass die Auffangraumwand einen Wandabschnitt aufweist, der der äußeren Druckausgleichsöffnung gegenüberliegt. Dadurch fängt dieser Wandabschnitt Flüssigkeit auf, die mit einer gewissen Geschwindigkeit durch die äußere Druckausgleichsöffnung in das Gehäuse gelangt. Dies kann beispielsweise vorkommen, wenn das Gehäuse mit Wasser angespritzt wird.

Eine vorteilhafte Möglichkeit sieht vor, dass der Auffangraum im Wesentlichen quaderförmig ausgebildet ist. Ein solcher quaderförmiger Auffangraum ist besonders einfach zu konstruieren und herzustellen.

Eine zweckmäßige Lösung sieht vor, dass der Auffangraum an freien verfügbaren Raum, der nicht durch die elektrischen oder elektronischen Bauteile belegt ist, angepasst ist. Dadurch kann die zur Verfügung stehende Platz in dem Gehäuse besonders effektiv ausgenutzt werden, sodass insgesamt das Gehäuse kleiner ausgebildet werden kann.

Eine weitere besonders vorteilhafte Möglichkeit sieht vor, dass eine Gehäusewand der Elektrik- und/oder Elektronikkomponente mindestens eine Leitungsöffnung aufweist, durch welche elektrische Kabel in den Innenraum des Gehäuses geführt sein können. Durch die Kabel können die elektrischen und/oder elektronischen Bauteile mit elektrischer Energie versorgt werden. Alternativ können solche Kabel auch dazu eingesetzt werden, um Informationen zu den Elektrik- und/oder Elektronikkomponenten oder von den Elektrik- und/oder Elektronikkomponenten nach außen zu übertragen, so dass mit Hilfe der Komponenten Informationen aufgenommen, übertragen und weitergegeben werden können.

Vorzugsweise ist die Leitungsöffnung in einem in Schwerkraftrichtung unteren Abschnitt des Gehäuses angeordnet. Des Weiteren ist bevorzugt, dass die elektrischen Kabel bezogen auf die Schwerkraftrichtung in Einbaulage im Wesentlichen horizontal oder schräg nach unten aus dem Gehäuse austreten.

Des Weiteren beruht die Erfindung auf der Grundidee, eine Elektrik- und/oder Elektronikkomponente mit einem Gehäuse gemäß der vorstehenden Beschreibung auszustatten, wobei mindestens ein elektrisches oder elektronisches Bauteil in dem Innenraum des Gehäuses angeordnet ist, und wobei mindestens ein elektrisches Kabel in den Innenraum geführt ist, das eine elektrische Verbindung mit dem mindestens einen elektrischen oder elektronischen Bauteil herstellt. Somit übertragen sich die Vorteile des Gehäuses auf die Elektrik- und/oder Elektronikkomponente, auf deren vorstehende Beschreibung insoweit Bezug genommen wird.

Eine vorteilhafte Weiterbildung sieht vor, dass das Gehäuse eine Leitungsöffnung aufweist, durch welche das mindestens eine Kabel verläuft, dass in der Leitungsöffnung eine Dichtmasse angeordnet ist, welche das Kabel umschließt und die Leitungsöffnung dichtend verschließt. Dadurch können Flüssigkeitsleckagen im Bereich der Leitungsöffnung verhindert werden. Somit kann die Wirkung der ersten und der zweiten Flüssigkeitsrückhaltevorrichtung des Gehäuses besonders effektiv ausgenutzt werden.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch,
- Fig. 1: Eine perspektivische Prinzipskizze einer Elektrik- und/oder Elektronikkomponente, und
- Fig. 2: eine perspektivische Rückansicht der Elektrik- und/oder Elektronikkomponente aus Fig. 1, wobei eine Rückwand ausgeblendet ist.

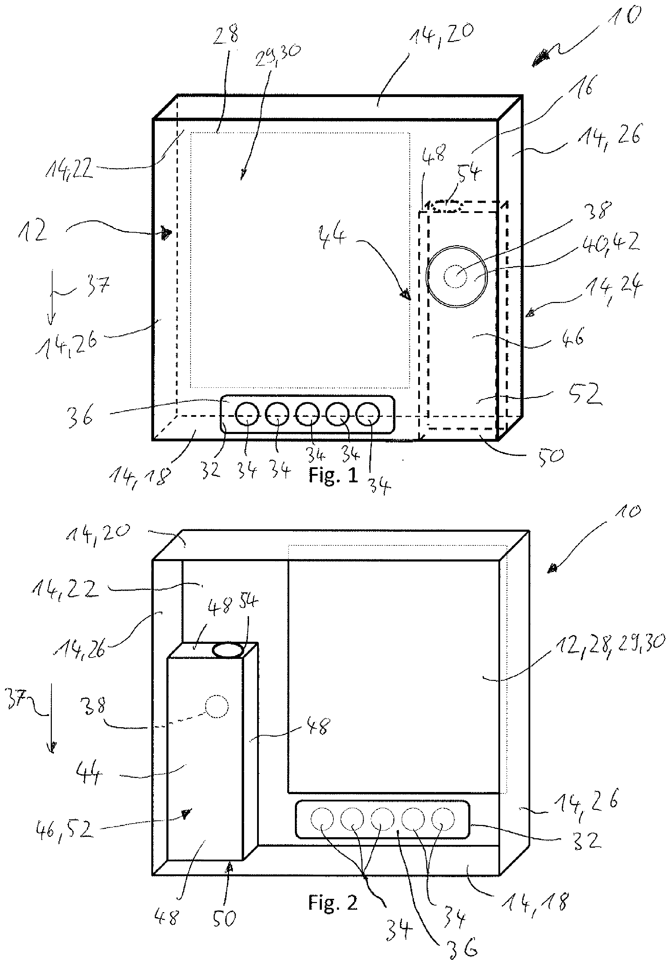

Eine in den Fig. 1 und 2 dargestellte erste Ausführungsform eines Gehäuses 10 für eine Elektrik- und/oder Elektronikkomponente 12 (E/E-Komponente) weist mehrere, beispielsweise sechs Gehäusewände 14 auf, welche einen Innenraum 16 des Gehäuses 10 umschließen, um darin elektrische und/oder elektronische Bauteile 29 der Elektrik- und/oder Elektronikkomponente 12 aufzunehmen. Vorzugsweise ist das Gehäuse 10 rechteckig ausgebildet. Das heißt, die sechs Gehäusewände 14 sind durch einen Boden 18, durch eine dem Boden 18 gegenüberliegende Deckenwand 20, eine Vorderwand 22, eine der Vorderwand 22 gegenüberliegende Hinterwand 24 und zwei seitliche Seitenwände 26 gebildet. Selbstverständlich kann das Gehäuse 10 auch andere Formen aufweisen.

Das Gehäuse 10 weist eine Aufnahme 28 für elektrische und/oder elektronische Bauteile 29 auf, die beispielsweise auf einer Platine 30 angeordnet sein können. Die Aufnahme 28 ist vorzugsweise an einer der Gehäusewände 14, beispielsweise an der Vorderwand 22, ausgebildet.

Des Weiteren weist das Gehäuse 10 eine Leitungsöffnung 32 auf, die in einer der Gehäusewände 14, vorzugsweise in der Vorderwand 22, ausgebildet ist. Durch die Leitungsöffnung 32 können elektrische Kabel 34 in das Gehäuse 10 hinein geführt werden. Durch die elektrischen Kabel 34 kann der Elektrik- und/oder Elektronikkomponente 12 elektrische Energie und/oder elektrische Signale zugeführt werden.

In der Leitungsöffnung 32 ist eine Dichtmasse 36 vorgesehen, welche die Leitungsöffnung 32 dichtend verschließt. Dabei umgibt die Dichtmasse 36 die in das Gehäuse 10 geführten elektrischen Kabel 34.

Das Gehäuse 10 weist ferner eine äußere Druckausgleichsöffnung 38 auf. Die äußere Druckausgleichsöffnung 38 ermöglicht einen Druckausgleich zwischen der Umgebung und dem Innenraum 16 des Gehäuses 10. Die äußere Druckausgleichsöffnung 38 ist in einer der Gehäusewände 14, vorzugsweise der Vorderwand 22, angeordnet.

Unter der Umgebung wird in der Beschreibung und den beigefügten Ansprüchen alles verstanden, das außerhalb des Gehäuses 10 ist.

Da die Elektrik- und/oder Elektronikkomponenten 12 durch Wasser gestört oder sogar beschädigt werden können, ist eine erste Flüssigkeitsrückhaltevorrichtung 40 vorgesehen. Die erste Flüssigkeitsrückhaltevorrichtung 40 weist eine Druckausgleichsmembran 42 auf, welche die äußere Druckausgleichsöffnung 38 abdeckt.
Die Druckausgleichsmembran 42 ist gasdurchlässig und wasserabweisend ausgebildet. Die Druckausgleichsmembran 42 kann beispielsweise aus dem Material Goretex hergestellt sein.

Durch die Gasdurchlässigkeit kann ein Druckausgleich zwischen dem Innenraum 16 und der Umgebung erfolgen. Die wasserabweisenden Eigenschaften der Druckausgleichsmembran 42 verhindern, dass Wasser durch die äußere Druckausgleichsöffnung 38 in den Innenraum 16 gelangen kann.

Es besteht die Möglichkeit, dass die Druckausgleichsmembran 42 beschädigt wird. In einem solchen Fall geht die wasserabweisende Wirkung der Druckausgleichsmembran 42 verloren, so dass Flüssigkeit, insbesondere Wasser durch die äußere Druckausgleichsöffnung 38 in das Gehäuse 10 gelangen kann.

Um in einem solchen Schadensfall die Lebensdauer der in dem Gehäuse 10 angeordneten Elektrik- und/oder Elektronikkomponente 12 zu erhöhen, ist eine zweite Flüssigkeitsrückhaltevorrichtung 44 vorgesehen. Die zweite Flüssigkeitsrückhaltevorrichtung 44 ist derart ausgebildet, dass Flüssigkeit, die durch die äußere Druckausgleichsöffnung 38 in das Gehäuse 10 eindringt, zumindest teilweise aufgefangen werden kann.

Die zweite Flüssigkeitsrückhaltevorrichtung 44 weist einen Auffangraum 46 auf, der in dem Innenraum 16 des Gehäuses 10 ausgebildet ist. Der Auffangraum 46 erstreckt sich in dem Innenraum 16 des Gehäuses 10 direkt angrenzend zu der äußeren Druckausgleichsöffnung 38. Dadurch gelangt Flüssigkeit, die durch eine beschädigte Druckausgleichsmembran 42 durch die äußere Druckausgleichsöffnung 38 in den Innenraum 16 des Gehäuses 10 gelangt zunächst in den Auffangraum 46.

Somit ist also durch die äußere Druckausgleichsöffnung 38 eine direkte fluidische Verbindung der Umgebung mit dem Auffangraum 46 gegeben, bei funktionierender Druckausgleichsmembran 42 besteht selbstverständlich nur eine gasfluidische Verbindung, während die flüssigkeitsfluidische Verbindung blockiert ist.

Der Auffangraum 46 ist zumindest teilweise durch eine Auffangraumwand 48 begrenzt. Zusätzlich kann der Auffangraum 46 durch eine oder mehrere der Gehäusewände 14 begrenzt sein. Insbesondere bietet sich hierfür die Gehäusewand 14 an, in welcher die äußere Druckausgleichsöffnung 38 ausgebildet ist. Zusätzlich kann allerdings auch beispielsweise der Boden 18 und eine der Seitenwände 26 den Auffangraum 46 begrenzen. Bei einem rechteckigen Auffangraum 46 ist der Auffangraum 46 vorzugsweise durch insgesamt sechs Wände begrenzt. Wie beispielhaft in Fig. 1 dargestellt ist, kann der Auffangraum 46 zusätzlich zu den Gehäusewänden 14 durch drei Wandabschnitte der Auffangraumwand 48 begrenzt sein.

Ein Wandabschnitt der Auffangraumwand 48 ist vorzugsweise der äußeren Druckausgleichsöffnung 38 gegenüber gestellt, so dass durch die äußere Druckausgleichsöffnung 38 eintretende Flüssigkeit durch diesen Wandabschnitt aufgefangen wird.

In Schwerkraftrichtung 37 nach unten ist der Auffangraum 46 durch einen Auffangraumboden 50 begrenzt, der entweder durch den Boden 18 des Gehäuses 10 oder durch einen separaten Wandabschnitt der Auffangraumwand 48 gebildet sein kann. Der Auffangraumboden 50 ist in Schwerkraftrichtung 37 betrachtet unterhalb der äußeren Druckausgleichsöffnung 38 angeordnet. Dadurch wird zwischen dem Auffangraumboden 50 und der äußeren Druckausgleichsöffnung 38 ein Flüssigkeitsreservoir 52 gebildet, in welchem Flüssigkeit, die durch die äußere Druckausgleichsöffnung 38 in das Gehäuse 10 gelangt ist, aufgefangen und zurückgehalten werden kann.

In Abhängigkeit von den herrschenden Druckbedingungen oder je nachdem, wie das Gehäuse 10 bewegt wird, kann Flüssigkeit, die in dem Flüssigkeitsreservoir 52 zurückgehalten wurde, das Gehäuse 10 durch die äußere Druckausgleichsöffnung 38 wieder verlassen.

Des Weiteren ist eine innere Druckausgleichsöffnung 54 vorgesehen, die in der Auffangraumwand 48 ausgebildet ist und ein Druckausgleich zwischen dem Innenraum 16 und dem Auffangraum 46 ermöglicht. Dadurch wird auch ein Druckausgleich zwischen dem Innenraum 16 und der Umgebung ermöglicht.

Die innere Druckausgleichsöffnung 54 liegt in Schwerkraftrichtung 37 gesehen oberhalb der äußeren Druckausgleichsöffnung 38. Dadurch kann verhindert werden, dass Flüssigkeit, die durch die äußere Druckausgleichsöffnung 38 in das Gehäuse 10 gelangt, direkt durch die innere Druckausgleichsöffnung 54 strömt. Somit kann durch die geschickte Anordnung der inneren Druckausgleichsöffnung 54 erreicht werden, dass die Flüssigkeit, insbesondere das Wasser, die in das Gehäuse 10 eingedrungen ist, zunächst in dem Auffangraum 46 zurückgehalten wird.

Eine nicht dargestellte zweite Ausführungsform des Gehäuses 10 unterscheidet sich von der in den Fig. 1 und 2 dargestellten ersten Ausführungsform des Gehäuses 10 dadurch, dass der Auffangraumboden 50 durch einen Wandabschnitt der Auffangraumwand 48 gebildet ist. Dadurch kann der Auffangraum 46 spezieller an Bauraumanforderungen angepasst werden.

Im Übrigen stimmt die nicht dargestellte zweite Ausführungsform des Gehäuses 10 mit der in den Fig. 1 und 2 dargestellten ersten Ausführungsform des Gehäuses 10 hinsichtlich Aufbau und Funktion überein, auf deren vorstehende Beschreibung insoweit Bezug genommen wird.

## Patentansprüche

1. Gehäuse (10) für eine Elektrik- und/oder Elektronikkomponente (12), das einen Innenraum (16) umschließt, in welchem elektrische und/oder elektronische Bauteile (29) aufgenommen werden können,
- mit einer äußeren Druckausgleichsöffnung (38), die in einer Gehäusewand (14) des Gehäuses (10) angeordnet ist, und
- mit einer ersten Flüssigkeitsrückhaltevorrichtung (40), die das Eindringen von Flüssigkeit, insbesondere Wasser, durch die äußere Druckausgleichsöffnung (38) in den Innenraum (16) behindert,
wobei die erste Flüssigkeitsrückhaltevorrichtung (40) eine Druckausgleichsmembran (42) aufweist, welche gasdurchlässig und wasserabweisend ist und welche die äußere Druckausgleichsöffnung (38) abdeckt,
**dadurch gekennzeichnet,**
**dass** das Gehäuse (10) eine zweite Flüssigkeitsrückhaltevorrichtung (44) aufweist, welche in dem Innenraum (16) des Gehäuses (10) angeordnet ist und welche Flüssigkeit, die durch die äußere Druckausgleichsöffnung (38) in das Gehäuse (10) eintritt, zumindest teilweise auffängt.

2. Gehäuse nach Anspruch 1,
**dadurch gekennzeichnet,**
**dass** die zweite Flüssigkeitsrückhaltevorrichtung (44) einen Auffangraum (46) aufweist, der an der äußeren Druckausgleichsöffnung (38) angeordnet ist.

3. Gehäuse nach Anspruch 2,
**dadurch gekennzeichnet,**
**dass** der Auffangraum (46) zumindest teilweise von einer Auffangraumwand (48) und der Gehäusewand (14), in welcher die äußere Druckausgleichsöffnung (38) angeordnet ist, umschlossen ist.

4. Gehäuse nach Anspruch 3,
**dadurch gekennzeichnet,**
**dass** das Gehäuse (10) eine innere Druckausgleichsöffnung (54) aufweist, die in der Auffangraumwand (48) angeordnet ist und durch welche der Auffangraum (46) fluidisch mit dem Innenraum (16) verbunden ist.

5. Gehäuse nach Anspruch 4,
**dadurch gekennzeichnet,**
**dass** die innere Druckausgleichsöffnung (54) in Schwerkraftrichtung (37) oberhalb der äußeren Druckausgleichsöffnung (38) angeordnet ist.

6. Gehäuse nach einem der Ansprüche 3 bis 5,
**dadurch gekennzeichnet,**
**dass** der Auffangraum (46) einen Auffangraumboden (50) umfasst, und
**dass** der Auffangraumboden (50) in Schwerkraftrichtung (37) unterhalb der äußeren Druckausgleichsöffnung (38) angeordnet ist.

7. Gehäuse nach einem der Ansprüche 3 bis 6,
**dadurch gekennzeichnet,**
**dass** die Auffangraumwand (48) einen Wandabschnitt aufweist, der der äußeren Druckausgleichsöffnung (38) gegenüber liegt.

8. Gehäuse nach einem der Ansprüche 2 bis 7,
**dadurch gekennzeichnet,**
**dass** der Auffangraum (46) im Wesentlichen quaderförmig ausgebildet ist.

9. Gehäuse nach einem der Ansprüche 1 bis 8,
**dadurch gekennzeichnet,**
**dass** eine Gehäusewand (14) mindestens eine Leitungsöffnung (32) aufweist, durch welche elektrische Kabel (34) in den Innenraum (16) des Gehäuses (10) geführt sein können oder geführt sind.

10. Elektrik- oder Elektronikkomponente mit einem Gehäuse (10) nach einem der Ansprüche 1 bis 9, **dadurch gekennzeichnet, dass** mindestens ein elektrisches oder elektronische Bauteil (29) in dem Innenraum (16) des Gehäuses (10) angeordnet ist, und
dass mindestens ein elektrisches Kabel (34) in den Innenraum (16) geführt ist, welches eine elektrische Verbindung mit dem mindestens einen elektrischen oder elektronischen Bauteil (29) herstellt.

11. Elektrik-oder Elektronikkomponente nach Anspruch 10,
**dadurch gekennzeichnet,**
**dass** das Gehäuse (10) eine Leitungsöffnung (32) aufweist, durch welche das mindestens eine elektrische Kabel (34) verläuft, und
**dass** in der Leitungsöffnung (32) eine Dichtmasse (36) angeordnet ist, welche das elektrische Kabel (34) umschließt und die Leitungsöffnung (32) dichtend verschließt.
